# EUROPEAN PATENT APPLICATION

(11) **EP 3 979 486 A1**
(43) Date of publication of application: **06.04.2022**
(21) Application number: 20813125.0
(22) Date of filing: 20.05.2020
(51) Int. Cl.: H02N 11/00, B81B 3/00

(54) **ELECTROSTATIC ACTUATOR HAVING MULTILAYER STRUCTURE**

(30) Priority: 31.05.2019 JP 2019102866
(71) Applicant: Strawb Inc., Yokohama-shi, Kanagawa 226-8510 (JP)
(72) Inventor: SANEYOSHI, Keiji, Yokohama-shi, Kanagawa 226-8510 (JP); ITO, Makoto, Yokohama-shi, Kanagawa 226-8510 (JP); IZUMITANI, Hikaru, Yokohama-shi, Kanagawa 226-8510 (JP)
(74) Representative: Hoffmann Eitle
(86) International application number: PCT/JP2020/019839
(87) International publication number: WO 2020/241387

(57) **Abstract**

Provided is a stacked electrostatic actuator capable of maintaining insulation performance between conductor layers even when an elastic layer is deformed due to a creep phenomenon. An electrostatic actuator includes a plurality of electrode films that are stacked and bonded, wherein each of the electrode films has a five-layer structure including an elastic layer, an insulating layer, a conductor layer, an insulating layer, and an elastic layer, a Young's modulus of a material for forming the elastic layers is smaller than a Young's modulus of a material for forming the insulating layers, and a spring constant of a material for forming the elastic layers increases as the electrode films extend in a stacking direction.

## Description

### TECHNICAL FIELD

The present invention relates to an electrostatic actuator having a multilayer structure.

### BACKGROUND ART

There is a technique disclosed in a patent publication related to a dielectric elastomer actuator and a drive system thereof obtained in order to provide a dielectric elastomer actuator having an easy to use structure and a drive system thereof, and the dielectric elastomer actuator includes a drive element A having a structure in which an elastomer is sandwiched between a pair of stretchable electrodes, a drive element B having a structure in which an elastomer is sandwiched between a pair of stretchable electrodes, and a connection portion that connects the drive element A and the drive element B in series, in which when a voltage is applied between the pair of electrodes included in the drive element A and the pair of electrodes included in the drive element B, the pairs of electrodes are displaced in a direction parallel to an electric field generated between the pairs of electrodes to extend the elastomers in a direction perpendicular to the electric field, and the extension of the elastomers acts on each other via the connection portion (PTL 1).

### CITATION LIST

### PATENT LITERATURE

PTL 1: Japanese Patent Application Publication No. 2018-33293 A

### SUMMARY OF INVENTION

### TECHNICAL PROBLEM

The conventional electrostatic actuator has a structure in which a dielectric elastomer that is an elastic material is sandwiched between conductor layers, and has a structure in which a distance between the conductor layers is reduced by an electrostatic attraction generated by a voltage applied between the conductor layers facing each other. The dielectric elastomer also works as an insulating material between the conductor layers. Here, when a voltage is applied to the electrostatic actuator for a long time and a compressive force is applied to the dielectric elastomer by an electrostatic attraction for a long time, in a case where the dielectric elastomer is soft, the dielectric elastomer extends in the lateral direction together with the conductors, and there is a concern that molecules of a material for forming a layer of the dielectric elastomer (elastic layer) move due to a creep phenomenon, the layer collapses, and dielectric breakdown occurs. For this reason, the conventional electrostatic actuator cannot be used for a long period of time, and is difficult to put into practical use. On the other hand, in a case where a dielectric elastomer having a low elasticity is used, the contraction rate decreases and a sufficient stroke cannot be secured, which is disadvantageous.

An object of the present invention is to provide a stacked electrostatic actuator capable of maintaining insulation performance between conductor layers even when an elastic layer is deformed due to a creep phenomenon. Another object of the present invention is to provide a stacked electrostatic actuator capable of easily securing a sufficient stroke.

### SOLUTION TO PROBLEM

In order to solve the above-described disadvantage, a stacked electrostatic actuator according to Claim 1 includes
a plurality of electrode films that are stacked and bonded,
wherein each of the electrode films has a five-layer structure including an elastic layer, an insulating layer, a conductor layer, an insulating layer, and an elastic layer, and
a Young's modulus of a material for forming the elastic layers is smaller than a Young's modulus of a material for forming the insulating layers.

In order to solve the above-described disadvantage, a stacked electrostatic actuator according to Claim 2 includes
a plurality of electrode films that are stacked and bonded,
wherein each of the electrode films has a five-layer structure including an elastic layer, an insulating layer, a conductor layer, an insulating layer, and an elastic layer, and
a spring constant of a material for forming the elastic layers increases as the electrode films extend in a stacking direction.

The stacked electrostatic actuator according to Claim 3 is
the stacked electrostatic actuator according to Claim 1 or 2,
wherein two adjacent ones of the electrode films are connected by adhesion, covalent bonding, or elastic body adhesive force between the elastic layers of the electrode films.

In order to solve the above-described disadvantage, a stacked electrostatic actuator according to Claim 4 includes
electrode layers each including a conductor layer and insulating layers disposed on both surfaces of the conductor layer, the electrode layers being stacked and bonded with an elastic layer interposed therebetween,
wherein a Young's modulus of a material for forming the elastic layer is smaller than a Young's modulus of a material for forming the insulating layers, or
a spring constant of a material for forming the elastic layer increases as the electrostatic actuator extends in a stacking direction.

The stacked electrostatic actuator according to Claim 5 is
the stacked electrostatic actuator according to Claim 4,
wherein the elastic layer is a structure including a plurality of columns separated from each other in a surface direction of the electrode layers.

### ADVANTAGEOUS EFFECTS OF INVENTION

According to the present invention, when a voltage is applied between the electrodes, the elastic layer is deformed softly, but the conductor layer is protected by the insulating layers. Even when the elastic layer is deformed due to a creep phenomenon by long-term voltage application, insulation of the conductor layer can be maintained by the insulating layers. As a result, it is possible to use an elastic material having a high elasticity, and it is possible to achieve both sufficient stroke and reliability.

### BRIEF DESCRIPTION OF DRAWINGS

FIG. 1 is a cross-sectional view of one layer of an electrode film included in a stacked electrostatic actuator according to a first embodiment.
FIG. 2 is a cross-sectional view of the entire stacked electrostatic actuator having a structure in which a plurality of the electrode films illustrated in FIG. 1 is stacked and bonded.
FIG. 3 is a view illustrating a state in which an external force in a direction of separating the stacked layers is applied between two end members and an interval between the electrode films is increased.
FIG. 4 is a view illustrating a state in which an interval between electrode films is reduced when a voltage is applied.
FIG. 5 is a cross-sectional view of a stacked electrostatic actuator according to a second embodiment.
FIG. 6 is a modification of the stacked electrostatic actuator illustrated in FIG. 5.

### DESCRIPTION OF EMBODIMENTS

### First Embodiment

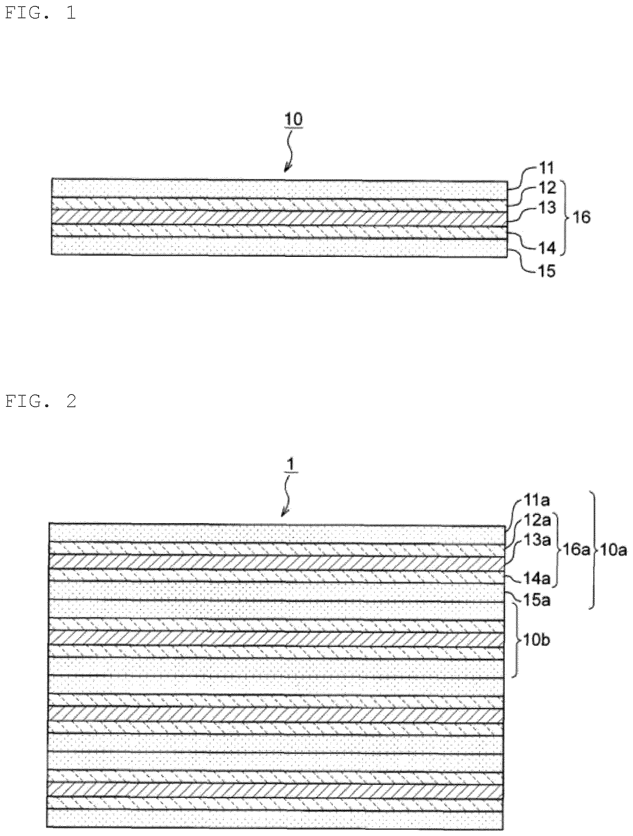

An embodiment of the present invention will be described below with reference to the drawings. FIG. 1 is a cross-sectional view of one layer of an electrode film 10 included in a stacked electrostatic actuator 1 according to a first embodiment. FIG. 2 is a cross-sectional view of the entire stacked electrostatic actuator 1 having a structure in which a plurality of the electrode films 10 illustrated in FIG. 1 is stacked and bonded.

### Configuration

The stacked electrostatic actuator 1 is configured by stacking and bonding a large number of the electrode films 10a and 10b sandwiched between two end members (not illustrated) (FIG. 2, described below). As illustrated in FIG. 1, each of the electrode films 10a and 10b has a five-layer structure including a first elastic layer 11a and 11b, a first insulating layer 12a and 12b, a conductor layer 13a and 13b, a second insulating layer 14a and 14b, and a second elastic layer 15a and 15b. In the following description, the first insulating layer 12a and 12b, the conductor layer 13a and 13b, and the second insulating layer 14a and 14b may be referred to as an electrode layer 16a and 16b.

For the first elastic layer 11, 11a and the second elastic layer 15, 15a, for example, a flexible material such as a gel, an acrylic resin, or a silicone resin is used. The conductor layer 13, 13a is made of, for example, a metal film such as copper, a conductive polymer, or a film having good electrical conductivity such as a conductive carbon allotrope (or a conductive mixture mainly including carbon). On the surfaces of the conductor layer 13, 13a, insulating layers (first insulating layer 12, 12a and second insulating layer 14, 14a) are formed by coating, bonding, deposition, or the like, and the conductor layer 13, 13a is sandwiched between the first insulating layer 12, 12a and the second insulating layer 14, 14a to form the electrode layer 16, 16a. As a material for the first and second insulating layers 12 and 14; 12a and 14a, for example, an insulating polymer material such as parylene (registered trademark) may be used, or a ceramic or glass material having good withstand voltage characteristics may be used. The thickness of the electrode layer 16, 16a is, for example, several micrometers.

Here, as a material for forming the first elastic layer 11, 11a and the second elastic layer 15, 15a, a material having a Young's modulus smaller than the Young's modulus of the material for forming the first insulating layer 12, 12a and the second insulating layer 14, 14a may be used. Alternatively, as a material for forming the first elastic layer 11, 11a and the second elastic layer 15, 15a, a material having characteristics of increasing the spring constant as the stacked electrostatic actuator 1 extends in the stacking direction may be used.

The electrode films 10a and 10b having the above-described configuration are stacked and bonded to form the stacked electrostatic actuator 1. The stack and bonding is performed, for example, by covalent bonding or elastic body adhesive force between elastic layers. Although the structure in which the elastic layers are bonded has been described, the electrode layers each including the conductor layer and the insulating layers disposed on both surfaces of the conductor layer may be stacked and bonded with an elastic layer interposed therebetween to form the electrostatic actuator.

### Operation

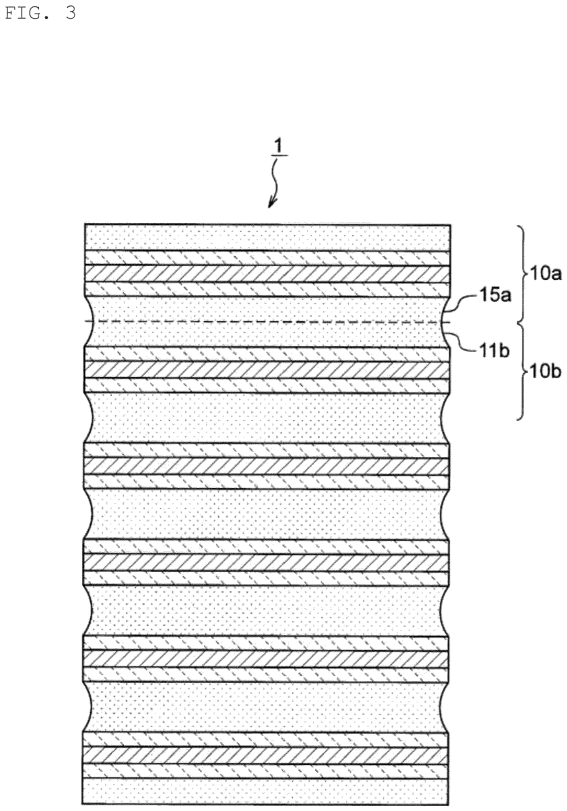

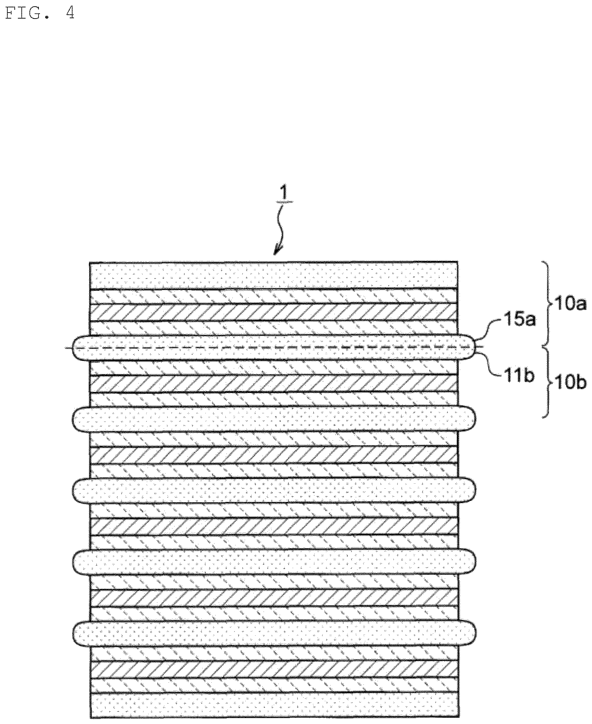

FIG. 3 is a view illustrating a state in which an external force in a direction of separating the stacked layers is applied between two end members (not illustrated) and the interval between the electrode films 10a and 10b is increased, and FIG. 4 is a view illustrating a state in which a voltage is applied and the interval between the electrode films 10a and 10b is reduced.

When receiving an external force in a direction of separating the electrode films 10, the elastic layers 15a and 11b between the first electrode film 10a and the second electrode film 10b extend in the stacking direction, and at the same time, are recessed in the inward direction between the electrode films in a direction perpendicular to the stacking direction (FIG. 3). When a voltage is applied between the conductor layers 13a and 13b of the first and second electrode films 10a and 10b, the first and second electrode films 10a and 10b attract each other, and the elastic layers 15a and 11b contract in the stacking direction, and at the same time, bulge outward between the electrode films 10a and 10b in a direction perpendicular to the stacking direction (FIG. 4).

When a voltage is applied, the elastic layers 15a and 11b are deformed, but the conductor layers 13a and 13b are protected by the insulating layers 14a and 12b. Therefore, even if creep occurs in the elastic layers 15a and 11b due to long-time voltage application, dielectric breakdown does not occur due to the existence of the insulating layers 14a and 12b between the conductor layers 13a and 13b and the elastic layers 15a and 11b, and the insulation performance of the conductor layers 13a and 13b is secured. As a result, it is possible to use a soft material for the elastic layers 15a and 11b, and it is possible to achieve both securing of a sufficient stroke as an electrostatic actuator and reliability on insulation performance.

### Second Embodiment

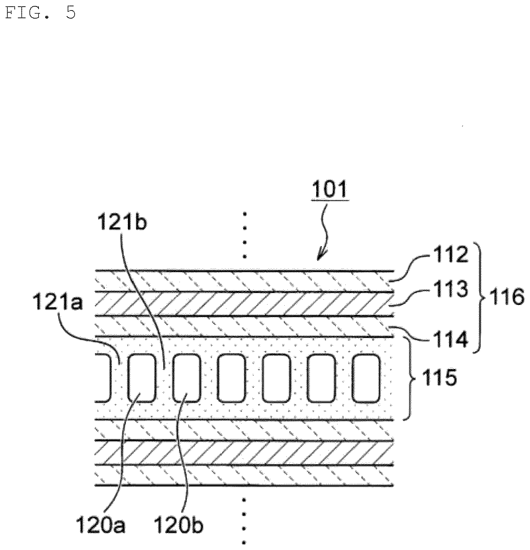

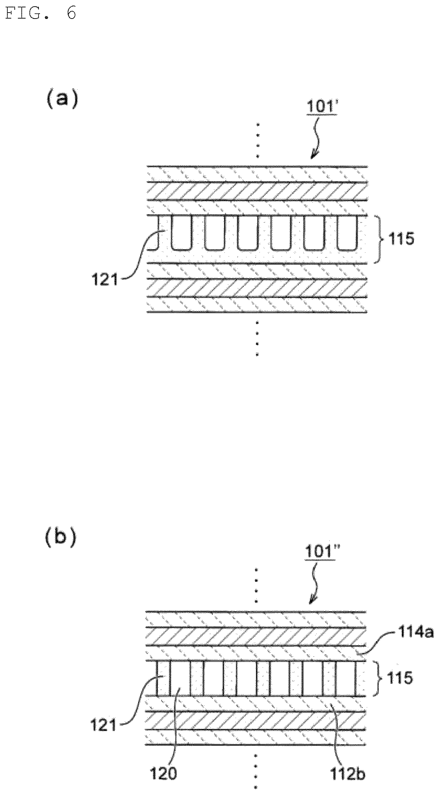

FIG. 5 is a cross-sectional view of a stacked electrostatic actuator 101 according to a second embodiment. FIG. 6 is a modification of the stacked electrostatic actuator 101 illustrated in FIG. 5. The same or similar elements as those of the stacked electrostatic actuator 1 according to the first embodiment are denoted by the same or similar reference signs, and the description thereof will not be repeated. As illustrated in FIG. 5, the stacked electrostatic actuator 101 is formed by stacking and bonding electrode layers 116, each of which includes a conductor layer 113 and insulating layers 112 and 114 disposed on respective surfaces of the conductor layer 113, with an elastic layer 115 interposed therebetween. The elastic layer 115 has a plurality of columns 121a and 121b separated from each other in the surface direction of the electrode layer 116 with gaps 120a and 120b therein.

In the stacked electrostatic actuator 1 according to the first embodiment, the deformation amount in the vicinity of the outer peripheral surface of the elastic layer bulging outward becomes large, and a large stress is generated in the elastic layers 11 and 15, particularly in the connection portion between the elastic layers 11 and 15 and the insulating layers 12 and 14, in the vicinity of the outer peripheral surface of the stacked electrostatic actuator 1 (see FIG. 4). On the other hand, by dividing the elastic layer 115 into columns as illustrated in FIG. 5, the columns 121a and 121b are deformed independently, so that the amount of deformation of the columns 121a and 121b is reduced, and the stress generated in the elastic layer 115 can be reduced. As a result, it is possible to achieve both securing of a sufficient stroke as a stacked electrostatic actuator and reliability on insulation performance. In addition, since all the columns 121a and 121b support each other against pulling, the strength is increased. The columns 121 may be connected at their ends (FIG. 6(a)), or may be individually and independently connected to the insulating layers 114a and 112b (FIG. 6(b)). In addition, the number, cross-sectional shape, and position of the columns are appropriately set considering the size of the surface of the electrode layer, the magnitude of the force applied to the stacked electrostatic actuator, required response performance, and the like.

### REFERENCE SIGNS LIST

- 1: Stacked electrostatic actuator
- 10, 10a, 10b: Electrode film
- 11, 11a, 11b: First elastic layer
- 12, 12a, 12b: First insulating layer
- 13, 13a, 13b: Conductor layer
- 14, 14a: Second insulating layer
- 15, 15a: Second elastic layer
- 16, 16a: Electrode layer
- 101: Stacked electrostatic actuator
- 113: Conductor layer
- 115: Elastic layer
- 116: Electrode portion
- 120a, 120b: Gap
- 121a, 121b: Column

## Claims

1. An electrostatic actuator comprising a plurality of electrode films that are stacked and bonded, wherein
each of the electrode films has a five-layer structure including an elastic layer, an insulating layer, a conductor layer, an insulating layer, and an elastic layer, and
a Young's modulus of a material for forming the elastic layers is smaller than a Young's modulus of a material for forming the insulating layers.

2. An electrostatic actuator comprising a plurality of electrode films that are stacked and bonded, wherein
each of the electrode films has a five-layer structure including an elastic layer, an insulating layer, a conductor layer, an insulating layer, and an elastic layer, and
a spring constant of a material for forming the elastic layers increases as the electrode films extend in a stacking direction.

3. The electrostatic actuator according to Claim 1 or 2, wherein
two adjacent ones of the electrode films are connected by adhesion, covalent bonding, or elastic body adhesive force between the elastic layers of the electrode films.

4. An electrostatic actuator comprising electrode layers each including a conductor layer and insulating layers disposed on both surfaces of the conductor layer, the electrode layers being stacked and bonded with an elastic layer interposed therebetween, wherein
a Young's modulus of a material for forming the elastic layer is smaller than a Young's modulus of a material for forming the insulating layers, or
a spring constant of a material for forming the elastic layer increases as the electrostatic actuator extends in a stacking direction.

5. The electrostatic actuator according to Claim 4, wherein
the elastic layer is a structure including a plurality of columns separated from each other in a surface direction of the electrode layers.
